# EUROPEAN PATENT APPLICATION

(11) **EP 4 597 582 A1**
(43) Date of publication of application: **06.08.2025**
(21) Application number: 23869644.7
(22) Date of filing: 16.05.2023
(51) Int. Cl.: H01L 31/05, H01L 31/18

(54) **SOLAR CELL SOLDERING METHOD**

(30) Priority: 27.09.2022 CN 202211183643
(71) Applicant: Changzhou Shichuang Energy Co., Ltd, Changzhou, Jiangsu 213300 (CN)
(72) Inventor: WANG, Weiliang, Changzhou, Jiangsu 213300 (CN); CHEN, Zhangyang, Pingxiang, Jiangxi 337000 (CN); CAO, Yuhong, Nanjing, Jiangsu 211100 (CN)
(74) Representative: Miller, Ronald Anthony
(86) International application number: PCT/CN2023/094515
(87) International publication number: WO 2024/066389

(57) **Abstract**

The present disclosure provides a solar cell soldering method, including a step of soldering a strip-shaped conductive connection member to a surface of a cell. The step of soldering the strip-shaped conductive connection member to the surface of the cell includes following substeps: providing, on an outer surface of a soldering carrier, a bearing surface for attaching the cell, and enabling the bearing surface to be an outwardly protruding cambered surface; attaching the cell to the bearing surface, and allowing a side surface of the cell on which the strip-shaped conductive connection member is to be soldered to face outwards to be an outer side surface of the cell; tightening and attaching the strip-shaped conductive connection member to the outer side surface of the cell; and heating the strip-shaped conductive connection member, such that the strip-shaped conductive connection member is soldered on the cell. The present disclosure can simplify a process for soldering the strip-shaped conductive connection member to the cell, optimize effective contact between the strip-shaped conductive connection member and the cell, improve soldering performance, and enhance soldering efficiency.

## Description

### TECHNICAL FIELD

The present disclosure relates to the field of photovoltaics, and specifically, to a solar cell soldering method.

### BACKGROUND

In a conventional manufacturing process of a crystalline silicon photovoltaic module, a first step is to solder solder ribbons for cells and connect the cells in series to form a cell string. Specifically, the method for forming a cell string is as follows. Solder ribbons and cells are alternately arranged in sequence, where a length of each of the solder ribbons is approximately twice a width of each of the cells, such that half of each of the solder ribbons is on a front surface of a respective cell and the other half of each of the solder ribbons is on a back surface of an adjacent cell. In this way, a cell string including a plurality of cells with upper and lower surfaces (namely positive and negative electrodes) being connected in series is formed in sequence. The cell string is then transported to a soldering station via an adsorption track. Generally, a plurality of pressure wires or pressure blocks are used to firmly press upper and lower solder ribbons against the cell. Through infrared heating, the solder ribbon is soldered onto the electrode on the surface of the cell.

When the solder ribbon is soldered onto the cell, the cell is generally placed flat on a flat and straight bearing surface. The solder ribbon is pressed against the cell mainly through a wire mesh or the pressure block that is perpendicular to a direction of the solder ribbon to make the solder ribbon be in contact with the cell for soldering. The solder ribbon is pressed at several scattered points, and it is impossible to ensure the effective contact for the unpressed area of the solder ribbon. Especially, when the solder ribbon is heated, the unpressed area of the solder ribbon is prone to elongation and distortion, resulting in a soldering failure. Additionally, when one pressure wire is used to press a plurality of solder ribbons perpendicularly in a crossed manner at one time, a middle solder ribbon fails to be effectively pressed due to insufficient pressure or the suspension of the pressure wire. This leads to ineffective soldering at the corresponding area. Consequently, the conventional process for soldering the solder ribbon onto the cell frequently suffers from dry solder joints.

In addition, in a photovoltaic module, specially-shaped solder ribbons such as triangular solder ribbons with optical advantages are increasingly being applied. In the conventional soldering process, it is difficult to ensure the direction consistency for the specially-shaped solder ribbons such as triangular solder ribbons through clamping, transporting, pressing, and the like, and it is also difficult to prevent the specially-shaped solder ribbons such as triangular solder ribbons from flipping over across an entire surface of the cell. Therefore, for the specially-shaped solder ribbons, especially ultra-fine specially-shaped solder ribbons, a novel soldering method and process is required to effectively ensure the orientation consistency, in order to effectively solder the specially-shaped solder ribbons.

Furthermore, in the development of photovoltaic technologies, increasing the number of busbars and silicon wafer thinning are still important directions for the development of cell module technologies. The pattern for collecting the current on the surface of the cell is a finger. Comprehensively considering the shading of light and the transmission loss of the current, the aspect ratio of the finger should be as large as possible. The pattern for connecting the cells in series and collecting the currents from the fingers is a busbar. To a certain extent, more busbars lead to a less silver consumption of the fingers, a narrower pattern, and a lower loss caused by the thermal resistance of the fingers, which can improve the efficiency while reducing the silver consumption of the cell. Consequently, a cell design continues to develop toward a configuration with more busbars. The cost of crystalline silicon accounts for about half of the cost of the photovoltaic module. A thicker silicon wafer leads to the more crystalline silicon material to be used and the higher cost of the crystalline silicon. Therefore, the application of a thin silicon wafer is also an important direction for the development of the photovoltaic module.

When more busbars are used for the cell, more and thinner solder ribbons are required. Currently, the diameter of the smallest round-wire solder ribbon used is less than 0.2 mm, and there are as many as 30 solder ribbons on a cell with a width of 210 mm. The conventional soldering device mainly uses clamps to grasp, pull, transport, and place the solder ribbons, and reduces deviation, rolling, and twisting of the solder ribbons through pressing via the pressure block. With so many and thin solder ribbons, the control complexity of the conventional soldering process increases dramatically. 1) One solder ribbon corresponds to one spool, and therefore, a large number of spools makes it difficult to design the spool position and perform pay-off, routing, and alignment at the same time. 2) Automation also requires a matching design that shortens the flow path of the solder wire and the cell, positions the solder ribbon, and ensures the upstream and downstream matching between various actions. 3) The influence from device disconnection and other failures has greatly increased, post-failure recovery is challenging, and the complexity of device maintenance also rises substantially.

In addition, in the development of silicon wafer thinning, a thinner silicon wafer results in greater warpage of the cell after the soldering, which increases risks of desoldering, hidden cracking, and fragmentation. Furthermore, cell warpage is also not conducive to subsequent stacking, lamination, and other procedures. At present, the thickness of a mainstream cell is about 150 um. With the development of cell technologies, the cell process can achieve mass production of increasingly thin cells. To jointly achieve the goal of reducing the cost of crystalline silicon for the module, there is an urgent need for a thin-silicon wafer soldering process compatible with the module.

### SUMMARY

An objective of the present disclosure is to provide a solar cell soldering method, including a step of soldering a strip-shaped conductive connection member to a surface of a cell, where the step of soldering the strip-shaped conductive connection member to the surface of the cell includes following substeps:
providing, on an outer surface of a soldering carrier, a bearing surface for attaching the cell, and enabling the bearing surface to be an outwardly protruding cambered surface (which may be an arc surface);
attaching the cell to the bearing surface, ensuring that the cell does not extend beyond the bearing surface to which the cell is attached, and allowing a side surface of the cell to face outwards to be an outer side surface of the cell, where the strip-shaped conductive connection member is to be soldered on the side surface (namely, allowing the side surface of the cell on which the strip-shaped conductive connection member is to be soldered to be opposite to the bearing surface);
tightening and attaching the strip-shaped conductive connection member to the outer side surface of the cell (namely, to the side surface of the cell opposite to the bearing surface) along a circumferential direction of the bearing surface, such that the strip-shaped conductive connection member firmly presses the cell onto the bearing surface; and
heating the strip-shaped conductive connection member, such that the strip-shaped conductive connection member is soldered on the cell.

Preferably, if the outer side surface of the cell is provided with a plurality of grid lines parallel to each other, when the cell is attached to the bearing surface, an extension direction of the plurality of grid lines on the outer side surface of the cell is allowed to be perpendicular to an axis of the bearing surface, and when the strip-shaped conductive connection member is tightened and attached to the outer side surface of the cell, the strip-shaped conductive connection member is correspondingly attached to the plurality of grid lines on the outer side surface of the cell.

Preferably, after the strip-shaped conductive connection member is soldered on the cell, the strip-shaped conductive connection member is cut off to leave a small section of the strip-shaped conductive connection member on the cell, and the small section of the strip-shaped conductive connection member is configured for a serial connection of the cell on which the small section of the strip-shaped conductive connection member is located (one end of the small section of the strip-shaped conductive connection member extends beyond the cell on which the small section of the strip-shaped conductive connection member is located, and the other end of the small section of the strip-shaped conductive connection member does not extend beyond the cell on which the small section of the strip-shaped conductive connection member is located), and then the cell is removed from the bearing surface of the soldering carrier (after the cell is removed, the cell can be flipped, and the step of soldering the strip-shaped conductive connection member to the surface of the cell is performed on the other surface of the cell again).

Preferably, the step of soldering the strip-shaped conductive connection member to the surface of the cell is performed on a front surface and a back surface of the cell individually to solder strip-shaped conductive connection members to the front surface and the back surface of the cell, respectively.

For a specific selection of the strip-shaped conductive connection member, a specific implementation of tightening and attaching the strip-shaped conductive connection member to the outer side surface of the cell, a specific implementation of heating the strip-shaped conductive connection member, and other related specific details, reference can be made to embodiments.

### Beneficial Effects

The present disclosure has following advantages and beneficial effects.

The present disclosure can simplify a process for soldering the strip-shaped conductive connection member (a solder wire or a solder ribbon) to the cell, optimize effective contact between the strip-shaped conductive connection member (the solder wire or the solder ribbon) and the cell, improve soldering performance, and enhance soldering efficiency.

In the present disclosure, the bearing surface of the soldering carrier is the outwardly protruding cambered surface, and the cell is attached to the bearing surface. In addition, the strip-shaped conductive connection member (the solder wire or the solder ribbon) is tightened and attached to the cell along a circumferential direction of the cambered surface of the bearing surface. During the soldering, the cell and the strip-shaped conductive connection member (the solder wire or the solder ribbon) are bent on the bearing surface along the circumferential direction of the cambered surface of the bearing surface, such that the strip-shaped conductive connection member (the solder wire or the solder ribbon) and the cell can be continuously and sufficiently attached together, sufficiently stressed, and fully in contact with each other.

The present disclosure can wind and solder the strip-shaped conductive connection member to a plurality of rows of cells at a time, which can improve the soldering efficiency.

The present disclosure also has the following advantages.

The present disclosure reduces dry solder joints. Because the strip-shaped conductive connection member (the solder wire or the solder ribbon) and the cell can be continuously attached together and uniformly stressed, the soldering is completed where the strip-shaped conductive connection member and the cell are in full contact with each other under stress. Therefore, the soldering is complete and sufficient, which can greatly reduce the dry solder joints.

In the present disclosure, the cell has a small warpage after the soldering. At present, the cell is generally placed flat on a flat and straight bearing surface, and then the strip-shaped conductive connection member (the solder wire or the solder ribbon) is laid on the cell and soldered. Because the thermal expansion of the strip-shaped conductive connection member (the solder wire or the solder ribbon) is typically greater than that of the cell (a silicon wafer), the cooling shrinkage of the strip-shaped conductive connection member (the solder wire or the solder ribbon) after post-soldering cooling causes the cell to curl towards the outer side surface (namely, the soldering surface), thereby leading the cell to warp. In the present disclosure, the bearing surface is an outwardly protruding cambered surface, and the bending direction of the bearing surface is exactly opposite to the curling direction of the cell after the post-soldering cooling, which effectively suppresses the warpage of the cell and greatly reduces the warpage amplitude of the cell after the soldering.

In the present disclosure, a small number of spools are used for the strip-shaped conductive connection member (the solder wire or the solder ribbon) and can be easily controlled. The present disclosure can use only one strip-shaped conductive connection member for winding around all cells on the soldering carrier. The strip-shaped conductive connection member (the solder wire or solder ribbon) for all the cells on the soldering carrier come from the same spool, so the number of spools is greatly reduced, which can simplify the design of device space. Maintenance and wire replacement operations for faults such as wire breakage and deviation of the strip-shaped conductive connection member (the solder wire or the solder ribbon) are also greatly simplified.

In the present disclosure, minimal deviation of the strip-shaped conductive connection member (the solder wire or the solder ribbon) is achieved in the winding process. The strip-shaped conductive connection member (the solder wire or the solder ribbon) can be directly connected to the cell after being pulled out from the spool, aligned with the grid lines on the cell, and tightened and fixed, which can completely eliminate the conventional actions of cutting, clamping, stretching, and transporting the strip-shaped conductive connection member (the solder wire or the solder ribbon), and almost completely avoid the possible deviation of the strip-shaped conductive connection member (the solder wire or the solder ribbon).

In the present disclosure, a large number of, e.g. hundreds of, small sections of the strip-shaped conductive connection member can be formed at a time through soldering the strip-shaped conductive connection member on a single cell (the small section of the strip-shaped conductive connection member is used for the serial connection of the cell on which the small section of the strip-shaped conductive connection member is located). Theoretically, the final number of small sections of the strip-shaped conductive connection member on the single cell is equal to the number of rotation turns of the side circumferential surface of the soldering carrier when the strip-shaped conductive connection member is wound, making it easy to control and implement.

The present disclosure can be applied to soldering of a specially-shaped solder ribbon (such as a triangular solder ribbon) that requires direction recognition. When the triangular solder ribbon is wound, the bearing surface (the outwardly protruding cambered surface) can automatically correct the direction of a top corner of the triangular solder ribbon, such that the top corner of the triangular solder ribbon faces upwards and a bottom surface of the triangular solder ribbon faces downwards. In this way, the specially-shaped solder ribbon (such as the triangular solder ribbon) can be soldered. The triangular solder ribbon is not liable to flip and achieves a high yield.

### BRIEF DESCRIPTION OF THE DRAWINGS

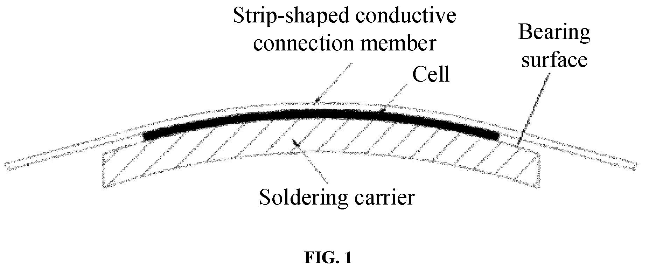

FIG. 1 to FIG. 5 are schematic diagrams of the present disclosure.

### DETAILED DESCRIPTION OF THE EMBODIMENTS

### SPECIFIC IMPLEMENTATIONS

Specific implementations of the present disclosure will be described in detail below with reference to the accompanying drawings and embodiments. The following embodiments are only used for describing the technical solutions of the present disclosure more clearly, and are not intended to limit the protection scope of the present disclosure.

The present disclosure provides a solar cell soldering method. A step of soldering a strip-shaped conductive connection member to a surface of a cell is performed on a front surface and a back surface of the cell individually to solder strip-shaped conductive connection members to the front surface and the back surface of the cell, respectively.

The step of soldering the strip-shaped conductive connection member to the surface of the cell includes the following substeps.

A bearing surface for attaching a cell is provided on an outer surface of a soldering carrier, the bearing surface is enabled to be an outwardly protruding cambered surface (which may be an arc surface), and an arc height of the cambered surface is allowed to be not greater than one fourth of an arc length.

The cell is attached to the bearing surface, it is ensured that the cell does not extend beyond the bearing surface to which the cell is attached, and a side surface of the cell on which the strip-shaped conductive connection member is to be soldered is allowed to face outwards to be an outer side surface of the cell (namely, the side surface of the cell on which the strip-shaped conductive connection member is to be soldered is allowed to be opposite to the bearing surface).

Then the strip-shaped conductive connection member is tightened and attached to the outer side surface of the cell (namely, to the side surface of the cell opposite to the bearing surface) along a circumferential direction of the bearing surface, such that the strip-shaped conductive connection member firmly presses the cell onto the bearing surface.

Then the strip-shaped conductive connection member is heated through direct heating, infrared heating, hot air heating, or the like, such that the strip-shaped conductive connection member is soldered on the cell.

After that, the strip-shaped conductive connection member is cut off to leave a small section of the strip-shaped conductive connection member on the cell, where the small section of the strip-shaped conductive connection member is used for serial connection of the cell on which the small section of the strip-shaped conductive connection member is located (one end of the small section of the strip-shaped conductive connection member extends beyond the cell on which the small section of the strip-shaped conductive connection member is located, and the other end of the small section of the strip-shaped conductive connection member does not extend beyond the cell on which the small section of the strip-shaped conductive connection member is located).

Then the cell is removed from the bearing surface of the soldering carrier (after the cell is removed, the cell can be flipped, and the step of soldering the strip-shaped conductive connection member to the surface of the cell is performed on the other surface of the cell again).

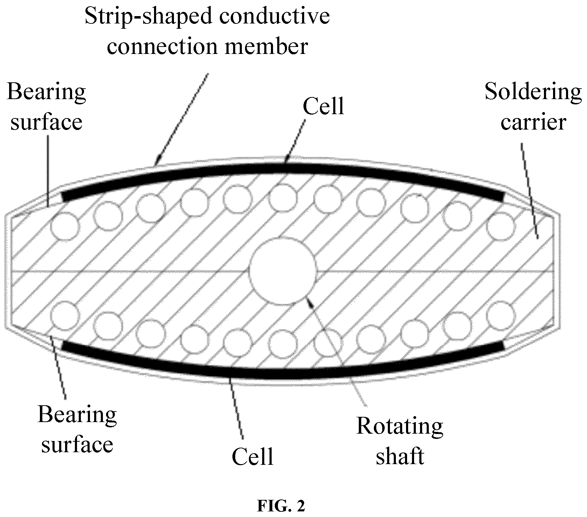

Specifically,
1) The bearing surface can be provided with a vacuum adsorption function (for example, suction ports can be uniformly distributed on the bearing surface for vacuum adsorption). In addition, when the cell is attached to the bearing surface, the vacuum adsorption is carried out on the cell through the bearing surface to ensure that the cell is stably adsorbed and attached on the bearing surface.
2) The soldering carrier can be provided with a heating function, and the cell on the bearing surface and the strip-shaped conductive connection member on the outer side surface of the cell are heated through the soldering carrier, such that the strip-shaped conductive connection member is soldered on the cell.
3) If the outer side surface of the cell is provided with a grid line, when the cell is attached to the bearing surface, an extension direction of the grid line on the outer side surface of the cell is allowed to be perpendicular to an axis of the bearing surface; and when the strip-shaped conductive connection member is tightened and attached to the outer side surface of the cell, the strip-shaped conductive connection member is correspondingly attached to the grid line on the outer side surface of the cell.
4) The strip-shaped conductive connection member may be a solder wire or a solder ribbon. If the strip-shaped conductive connection member has a flat and straight bottom surface for soldering to the cell (for example, the strip-shaped conductive connection member has a triangular or rectangular cross-section), when the strip-shaped conductive connection member is tightened and attached to the outer side surface of the cell, the flat and straight bottom surface of the strip-shaped conductive connection member is allowed to face the outer side surface of the cell, such that the strip-shaped conductive connection member is stably attached to the outer side surface of the cell.
   For example, the strip-shaped conductive connection member may be a triangular solder ribbon. When the strip-shaped conductive connection member (the triangular solder ribbon) is tightened and attached to the outer side surface of the cell, a bottom surface of the triangular solder ribbon is allowed to face the outer side surface of the cell (namely a top corner of the triangular solder ribbon is allowed to be opposite to the outer side surface of the cell), such that the strip-shaped conductive connection member (the triangular solder ribbon) is stably attached to the outer side surface of the cell.
5) As shown in FIG. 1, the strip-shaped conductive connection member is tightened and attached to the outer side surface of the cell by allowing the strip-shaped conductive connection member to span across the cell along the circumferential direction of the bearing surface and pulling sections of the strip-shaped conductive connection member respectively located outside two sides of the cell tight towards the soldering carrier and/or the bearing surface.
6) As shown in FIG. 2 to FIG. 5, a rotating shaft can also be provided on the soldering carrier, and the outer surface of the soldering carrier includes a side circumferential surface around the rotating shaft. The bearing surface is placed on the side circumferential surface of the soldering carrier, and the axis of the bearing surface is parallel to or collinear with an axis of the rotating shaft. Moreover, the strip-shaped conductive connection member is tightened and attached to the outer side surface of the cell by winding the strip-shaped conductive connection member along a circumferential direction of the side circumferential surface of the soldering carrier and pulling the strip-shaped conductive connection member tight to the cell on the side circumferential surface of the soldering carrier.

In addition, if the axis of the rotating shaft is located on a centerline of the soldering carrier, when the strip-shaped conductive connection member is wound along the circumferential direction of the side circumferential surface of the soldering carrier and pulled tight to the cell on the side circumferential surface of the soldering carrier, the side circumferential surface of the soldering carrier is rotated around the axis of the rotating shaft, making it convenient to wind the strip-shaped conductive connection member.

Moreover, only one strip-shaped conductive connection member can be used, and the strip-shaped conductive connection member is wound along the circumferential direction of the side circumferential surface of the soldering carrier and pulled tight to the cell on the side circumferential surface of the soldering carrier.

More preferably, a plurality of rows of bearing surfaces can be provided on the side circumferential surface of the soldering carrier, where the plurality of rows of bearing surfaces are sequentially disposed along the circumferential direction of the side circumferential surface of the soldering carrier, bearing surfaces in an identical row of the plurality of rows of bearing surfaces are sequentially disposed along an axial direction of the rotating shaft, and an axis of each bearing surface of the plurality of rows of bearing surfaces is parallel to or collinear with the axis of the rotating shaft. More specifically, the plurality of rows of bearing surfaces may be uniformly distributed along the circumferential direction of the side circumferential surface of the soldering carrier, and the plurality of rows of bearing surfaces may even be uniformly distributed on the side circumferential surface of the soldering carrier. A plurality of rows of cells are respectively attached to the plurality of rows of bearing surfaces, so as to wind and solder the strip-shaped conductive connection member to the plurality of rows of cells at a time, which can improve soldering efficiency.

Specific embodiments of a method for winding the strip-shaped conductive connection member in the present disclosure are as follows.

### Embodiment 1

As shown in FIG. 2, this embodiment provides a solar cell soldering method. A step of soldering a strip-shaped conductive connection member to a surface of a cell is performed on a front surface and a back surface of the cell individually to solder strip-shaped conductive connection members to the front surface and the back surface of the cell, respectively. In addition, the front and back surfaces of the cell each are provided with a plurality of grid lines parallel to each other.

The step of soldering the strip-shaped conductive connection member to the surface of the cell includes the following substeps.

A soldering carrier with a rotating shaft is provided, with an axis of the rotating shaft located on a centerline of the soldering carrier, and the soldering carrier is provided with a side circumferential surface around the rotating shaft. Two bearing surfaces that can be used for attaching the cell are provided on the side circumferential surface of the soldering carrier, where the two bearing surfaces are outwardly protruding cambered surfaces (which may be arc surfaces) and are symmetrically arranged, and an axis of each of the two bearing surfaces is parallel to or collinear with the axis of the rotating shaft. The two bearing surfaces each are provided with a vacuum adsorption function (for example, suction ports are uniformly distributed on each of the two bearing surfaces for vacuum adsorption). The soldering carrier is provided with a heating function that can heat the two bearing surfaces.

A cell is attached to each of the two bearing surfaces. It is ensured that the cell does not extend beyond the respective bearing surface to which the cell is attached, and a side surface of the cell on which the strip-shaped conductive connection member is to be soldered is allowed to face outwards to be an outer side surface of the cell (namely, the side surface of the cell on which the strip-shaped conductive connection member is to be soldered is allowed to be opposite to the respective bearing surface). In addition, an extension direction of the plurality of grid lines on the outer side surface of the cell (namely the side surface of the cell opposite to the respective bearing surface) is allowed to be perpendicular to the axis of the respective bearing surface (namely perpendicular to the axis of the rotating shaft). The vacuum adsorption is carried out on the cell on the respective bearing surface through the respective bearing surface to ensure that the cell is stably absorbed and attached on the respective bearing surface.

Then, the strip-shaped conductive connection member is tightened and attached to the outer side surface of the cell by winding the strip-shaped conductive connection member along a circumferential direction of the side circumferential surface of the soldering carrier and pulling the strip-shaped conductive connection member tight to the cell on the side circumferential surface of the soldering carrier. When the strip-shaped conductive connection member is wound, it is ensured that the strip-shaped conductive connection member is correspondingly attached to the plurality of grid lines on the outer side surface of the cell. Specifically, only one strip-shaped conductive connection member may be used for winding. The strip-shaped conductive connection member may be a flat solder ribbon. When the flat solder ribbon is wound, a bottom surface of the flat solder ribbon is allowed to face the outer side surface of the cell, such that the flat solder ribbon is stably attached to the corresponding grid line on the outer side surface of the cell. When the strip-shaped conductive connection member is wound, the side circumferential surface of the soldering carrier is enabled to rotate around the axis of the rotating shaft, which can facilitate the winding of the strip-shaped conductive connection member. More specifically, an external mechanism (such as a motor) can be used to drive the rotating shaft to rotate around its own axis, and the rotating shaft drives the soldering carrier to rotate as a whole, such that the side circumferential surface of the soldering carrier rotates around the axis of the rotating shaft.

Then, the strip-shaped conductive connection member is heated, such that the strip-shaped conductive connection member is synchronously soldered on each cell. Specifically, 1) The cell on each bearing surface and the strip-shaped conductive connection member on the outer side surface of the cell can be heated through the soldering carrier, such that the strip-shaped conductive connection member is synchronously soldered on each cell. 2) It is also possible to heat the outer side surface of each cell and the strip-shaped conductive connection member on the outer side surface through infrared heating (for example, by performing linear infrared irradiation on the outer side surface of each cell and the strip-shaped conductive connection member on the outer side surface), such that the strip-shaped conductive connection member is synchronously soldered on each cell.

After that, the strip-shaped conductive connection member is cut off to leave a small section of the strip-shaped conductive connection member on the cell, where the small section of the strip-shaped conductive connection member is used for a serial connection of the cell on which the small section of the strip-shaped conductive connection member is located (one end of the small section of the strip-shaped conductive connection member extends beyond the cell on which the small section of the strip-shaped conductive connection member is located, and the other end of the small section of the strip-shaped conductive connection member does not extend beyond the cell on which the small section of the strip-shaped conductive connection member is located).

Then the cell is removed from the respective bearing surface of the soldering carrier (after the cell is removed, the cell can be flipped, and the step of soldering the strip-shaped conductive connection member to the surface of the cell is performed on the other surface of the cell again).

### Embodiment 2

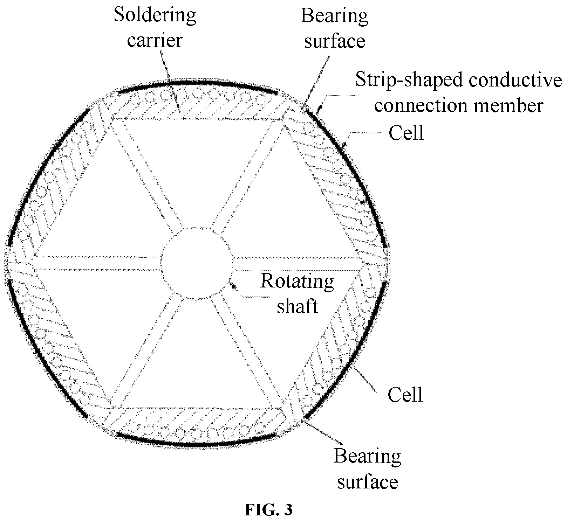

As shown in FIG. 3, this embodiment provides a solar cell soldering method. A step of soldering a strip-shaped conductive connection member to a surface of a cell is performed on a front surface and a back surface of the cell individually to solder strip-shaped conductive connection members to the front surface and the back surface of the cell, respectively. In addition, the front and back surfaces of the cell each are provided with a plurality of grid lines parallel to each other.

The step of soldering the strip-shaped conductive connection member to the surface of the cell includes the following substeps.

A soldering carrier with a rotating shaft is provided, with an axis of the rotating shaft located on a centerline of the soldering carrier, and the soldering carrier is provided with a side circumferential surface around the rotating shaft. The side circumferential surface of the soldering carrier is surrounded by a plurality of bearing surfaces that can be used for attaching the cell (a main body of the soldering carrier may be a prism that is coaxial with the rotating shaft), where the plurality of bearing surfaces are outwardly protruding cambered surfaces (which may be arc surfaces) and an axis of each of the bearing surfaces is parallel to or collinear with the axis of the rotating shaft. The bearing surfaces each are provided with a vacuum adsorption function (for example, suction ports are uniformly distributed on each of the bearing surfaces for vacuum adsorption). The soldering carrier is provided with a heating function that can heat the bearing surfaces.

A cell is attached to each of the plurality of bearing surfaces. It is ensured that the cell does not extend beyond the respective bearing surface to which the cell is attached, and a side surface of the cell on which the strip-shaped conductive connection member is to be soldered is allowed to face outwards to be an outer side surface of the cell (namely, the side surface of the cell on which the strip-shaped conductive connection member is to be soldered is allowed to be opposite to the respective bearing surface). In addition, an extension direction of the plurality of grid lines on the outer side surface of the cell (namely the side surface of the cell opposite to the respective bearing surface) is allowed to be perpendicular to the axis of the respective bearing surface (namely perpendicular to the axis of the rotating shaft). The vacuum adsorption is carried out on the cell on the respective bearing surface through the respective bearing surface to ensure that the cell is stably absorbed and attached on the respective bearing surface.

Then, the strip-shaped conductive connection member is tightened and attached to the outer side surface of the cell by winding the strip-shaped conductive connection member along a circumferential direction of the side circumferential surface of the soldering carrier and pulling the strip-shaped conductive connection member tight to the cell on the side circumferential surface of the soldering carrier. When the strip-shaped conductive connection member is wound, it is ensured that the strip-shaped conductive connection member is correspondingly attached to the plurality of grid lines on the outer side surface of the cell. Specifically, only one strip-shaped conductive connection member may be used for winding. The strip-shaped conductive connection member may be a round-wire solder ribbon. When the strip-shaped conductive connection member is wound, the side circumferential surface of the soldering carrier is enabled to rotate around the axis of the rotating shaft, which can facilitate the winding of the strip-shaped conductive connection member. More specifically, an external mechanism (such as a motor) can be used to drive the rotating shaft to rotate around its own axis, and the rotating shaft drives the soldering carrier to rotate as a whole, such that the side circumferential surface of the soldering carrier rotates around the axis of the rotating shaft.

Then, the strip-shaped conductive connection member is heated, such that the strip-shaped conductive connection member is synchronously soldered on each cell. Specifically, 1) The cell on each bearing surface and the strip-shaped conductive connection member on the outer side surface of the cell can be heated through the soldering carrier, such that the strip-shaped conductive connection member is synchronously soldered on each cell. 2) It is also possible to heat the outer side surface of each cell and the strip-shaped conductive connection member on the outer side surface through hot air heating (for example, by using hot air to blow the outer side surface of each cell and the strip-shaped conductive connection member on the outer side surface), such that the strip-shaped conductive connection member is synchronously soldered on each cell.

After that, the strip-shaped conductive connection member is cut off to leave a small section of the strip-shaped conductive connection member on the cell, where the small section of the strip-shaped conductive connection member is used for serial connection of the cell on which the small section of the strip-shaped conductive connection member is located (one end of the small section of the strip-shaped conductive connection member extends beyond the cell on which the small section of the strip-shaped conductive connection member is located, and the other end of the small section of the strip-shaped conductive connection member does not extend beyond the cell on which the small section of the strip-shaped conductive connection member is located).

Then the cell is removed from the respective bearing surface of the soldering carrier (after the cell is removed, the cell can be flipped, and the step of soldering the strip-shaped conductive connection member to the surface of the cell is performed on the other surface of the cell again).

### Embodiment 3

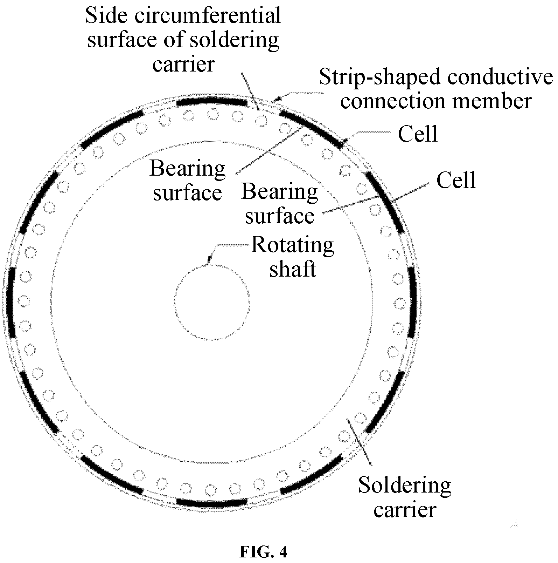

As shown in FIG. 4, this embodiment provides a solar cell soldering method. A step of soldering a strip-shaped conductive connection member to a surface of a cell is performed on a front surface and a back surface of the cell individually to solder strip-shaped conductive connection members to the front surface and the back surface of the cell, respectively. In addition, the front and back surfaces of the cell each are provided with a plurality of grid lines parallel to each other.

The step of soldering the strip-shaped conductive connection member to the surface of the cell includes the following substeps.

A soldering carrier with a rotating shaft is provided, with an axis of the rotating shaft located on a centerline of the soldering carrier, and the soldering carrier is provided with a side circumferential surface around the rotating shaft. The side circumferential surface of the soldering carrier is a circumferential surface that is coaxial with the rotating shaft (a main body of the soldering carrier may be a cylinder that is coaxial with the rotating shaft). The side circumferential surface of the soldering carrier is sequentially divided into a plurality of cambered areas at intervals along a circumferential direction of the side circumferential surface of the soldering carrier, and the plurality of cambered areas are uniformly distributed along the circumferential direction of the side circumferential surface of the soldering carrier. The cambered areas are bearing surfaces that can be used for attaching the cell. The bearing surfaces each are provided with a vacuum adsorption function (for example, suction ports are uniformly distributed on each of the bearing surfaces for vacuum adsorption). The soldering carrier is provided with a heating function that can heat the bearing surfaces.

A cell is attached to each of the bearing surfaces. It is ensured that the cell does not extend beyond the respective bearing surface to which the cell is attached, and a side surface of the cell on which the strip-shaped conductive connection member is to be soldered is allowed to face outwards to be an outer side surface of the cell (namely, the side surface of the cell on which the strip-shaped conductive connection member is to be soldered is allowed to be opposite to the respective bearing surface). In addition, an extension direction of the plurality of grid lines on the outer side surface of the cell (namely the side surface of the cell opposite to the respective bearing surface) is allowed to be perpendicular to an axis of the respective bearing surface (namely perpendicular to the axis of the rotating shaft). The vacuum adsorption is carried out on the cell on the respective bearing surface through the respective bearing surface to ensure that the cell is stably absorbed and attached on the respective bearing surface.

Then, the strip-shaped conductive connection member is tightened and attached to the outer side surface of the cell by winding the strip-shaped conductive connection member along the circumferential direction of the side circumferential surface of the soldering carrier and pulling the strip-shaped conductive connection member tight to the cell on the side circumferential surface of the soldering carrier. When the strip-shaped conductive connection member is wound, it is ensured that the strip-shaped conductive connection member is correspondingly attached to the plurality of grid lines on the outer side surface of the cell. Specifically, only one strip-shaped conductive connection member may be used for winding. The strip-shaped conductive connection member may be a triangular solder ribbon. When the triangular solder ribbon is wound, a bottom surface of the triangular solder ribbon is allowed to face the outer side surface of the cell (that is, a top corner of the triangular solder ribbon is opposite to the outer sider surface of the cell), such that the triangular solder ribbon is stably attached to the corresponding grid line on the outer side surface of the cell. In addition, in a process of winding the triangular solder ribbon, a state in which the bottom surface of the triangular solder ribbon is attached to the outer side surface of the cell is the most stable. Therefore, in the winding process, the direction of the top corner of the triangular solder ribbon can be automatically corrected, such that the top corner faces upwards and the bottom surface faces downwards. In this way, the triangular solder ribbon is stably attached to the outer side surface of the cell. When the strip-shaped conductive connection member is wound, the side circumferential surface of the soldering carrier is enabled to rotate around the axis of the rotating shaft, which can facilitate the winding of the strip-shaped conductive connection member. More specifically, an external mechanism (such as a motor) can be used to drive the rotating shaft to rotate around its own axis, and the rotating shaft drives the soldering carrier to rotate as a whole, such that the side circumferential surface of the soldering carrier rotates around the axis of the rotating shaft.

Then, the strip-shaped conductive connection member is heated, such that the strip-shaped conductive connection member is synchronously soldered on each cell. Specifically, 1) The cell on each bearing surface and the strip-shaped conductive connection member on the outer side surface of the cell can be heated through the soldering carrier, such that the strip-shaped conductive connection member is synchronously soldered on each cell. 2) It is also possible to heat the outer side surface of each cell and the strip-shaped conductive connection member on the outer side surface through hot air heating (for example, by using hot air to blow the outer side surface of each cell and the strip-shaped conductive connection member on the outer side surface), such that the strip-shaped conductive connection member is synchronously soldered on each cell.

After that, the strip-shaped conductive connection member is cut off to leave a small section of the strip-shaped conductive connection member on the cell, where the small section of the strip-shaped conductive connection member is used for serial connection of the cell on which the small section of the strip-shaped conductive connection member is located (one end of the small section of the strip-shaped conductive connection member extends beyond the cell on which the small section of the strip-shaped conductive connection member is located, and the other end of the small section of the strip-shaped conductive connection member does not extend beyond the cell on which the small section of the strip-shaped conductive connection member is located).

Then the cell is removed from the respective bearing surface of the soldering carrier (after the cell is removed, the cell can be flipped, and the step of soldering the strip-shaped conductive connection member to the surface of the cell is performed on the other surface of the cell again).

### Embodiment 4

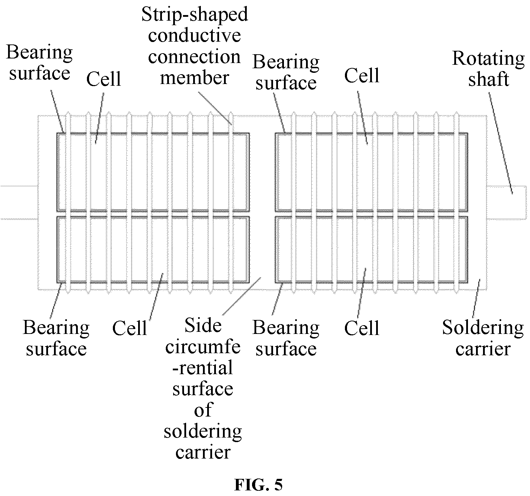

As shown in FIG. 5, this embodiment provides a solar cell soldering method. A step of soldering a strip-shaped conductive connection member to a surface of a cell is performed on a front surface and a back surface of the cell individually to solder strip-shaped conductive connection members to the front surface and the back surface of the cell, respectively. In addition, the front and back surfaces of the cell each are provided with a plurality of grid lines parallel to each other.

The step of soldering the strip-shaped conductive connection member to the surface of the cell includes the following substeps.

A soldering carrier with a rotating shaft is provided, with an axis of the rotating shaft located on a centerline of the soldering carrier, and the soldering carrier is provided with a side circumferential surface around the rotating shaft. The side circumferential surface of the soldering carrier is a circumferential surface that is coaxial with the rotating shaft (a main body of the soldering carrier may be a cylinder that is coaxial with the rotating shaft). The side circumferential surface of the soldering carrier is divided into a plurality of rows of cambered areas, where the plurality of rows of cambered areas are sequentially arranged at intervals along a circumferential direction of the side circumferential surface of the soldering carrier, and cambered areas in an identical row of the plurality of rows of cambered areas are sequentially arranged at intervals along an axial direction of the rotating shaft. The cambered areas are bearing surfaces that can be used for attaching the cell. The bearing surfaces each are provided with a vacuum adsorption function (for example, suction ports are uniformly distributed on each of the bearing surfaces for vacuum adsorption). The soldering carrier is provided with a heating function that can heat the bearing surfaces.

A cell is attached to each of the bearing surfaces. It is ensured that the cell does not extend beyond the respective bearing surface to which the cell is attached, and a side surface of the cell on which the strip-shaped conductive connection member is to be soldered is allowed to face outwards to be an outer side surface of the cell (namely, the side surface of the cell on which the strip-shaped conductive connection member is to be soldered is allowed to be opposite to the respective bearing surface). In addition, an extension direction of the plurality of grid lines on the outer side surface of the cell (namely the side surface of the cell opposite to the respective bearing surface) is allowed to be perpendicular to an axis of the respective bearing surface (namely perpendicular to the axis of the rotating shaft). The vacuum adsorption is carried out on the cell on the respective bearing surface through the respective bearing surface to ensure that the cell is stably absorbed and attached on the respective bearing surface.

Then, the strip-shaped conductive connection member is tightened and attached to the outer side surface of the cell by winding the strip-shaped conductive connection member along the circumferential direction of the side circumferential surface of the soldering carrier and pulling the strip-shaped conductive connection member tight to the cell on the side circumferential surface of the soldering carrier. When the strip-shaped conductive connection member is wound, it is ensured that the strip-shaped conductive connection member is correspondingly attached to the plurality of grid lines on the outer side surface of the cell. Specifically, only one strip-shaped conductive connection member may be used for winding. The strip-shaped conductive connection member may be a triangular solder ribbon. When the triangular solder ribbon is wound, a bottom surface of the triangular solder ribbon is allowed to face the outer side surface of the cell (that is, a top corner of the triangular solder ribbon is opposite to the outer sider surface of the cell), such that the triangular solder ribbon is stably attached to the corresponding grid line on the outer side surface of the cell. In addition, in a process of winding the triangular solder ribbon, a state in which the bottom surface of the triangular solder ribbon is attached to the outer side surface of the cell is the most stable. Therefore, in the winding process, the direction of the top corner of the triangular solder ribbon can be automatically corrected, such that the top corner faces upwards and the bottom surface faces downwards. In this way, the triangular solder ribbon is stably attached to the outer side surface of the cell. When the strip-shaped conductive connection member is wound, the side circumferential surface of the soldering carrier is enabled to rotate around the axis of the rotating shaft, which can facilitate the winding of the strip-shaped conductive connection member. More specifically, an external mechanism (such as a motor) can be used to drive the rotating shaft to rotate around its own axis, and the rotating shaft drives the soldering carrier to rotate as a whole, such that the side circumferential surface of the soldering carrier rotates around the axis of the rotating shaft.

Then, the strip-shaped conductive connection member is heated, such that the strip-shaped conductive connection member is synchronously soldered on each cell. Specifically: 1) The cell on each bearing surface and the strip-shaped conductive connection member on the outer side surface of the cell can be heated through the soldering carrier, such that the strip-shaped conductive connection member is synchronously soldered on each cell. 2) It is also possible to heat the outer side surface of each cell and the strip-shaped conductive connection member on the outer side surface through infrared heating (for example, by performing linear infrared irradiation on the outer side surface of each cell and the strip-shaped conductive connection member on the outer side surface), such that the strip-shaped conductive connection member is synchronously soldered on each cell.

After that, the strip-shaped conductive connection member is cut off to leave a small section of the strip-shaped conductive connection member on the cell, where the small section of the strip-shaped conductive connection member is used for serial connection of the cell on which the small section of the strip-shaped conductive connection member is located (one end of the small section of the strip-shaped conductive connection member extends beyond the cell on which the small section of the strip-shaped conductive connection member is located, and the other end of the small section of the strip-shaped conductive connection member does not extend beyond the cell on which the small section of the strip-shaped conductive connection member is located).

Then the cell is removed from the respective bearing surface of the soldering carrier (after the cell is removed, the cell can be flipped, and the step of soldering the strip-shaped conductive connection member to the surface of the cell is performed on the other surface of the cell again).

In Embodiment 4, the strip-shaped conductive connection member can be wound and soldered to a plurality of rows of cells at a time, which can improve the soldering efficiency.

The above description is only preferred implementations of the present disclosure. It should be noted that those skilled in the art can make several improvements and modifications without departing from the technical principles of the present disclosure, and these improvements and modifications should also be construed as falling within the protection scope of the present disclosure.

## Claims

1. A solar cell soldering method, comprising a step of soldering a strip-shaped conductive connection member to a surface of a cell, **characterized in that** the step of soldering the strip-shaped conductive connection member to the surface of the cell comprises following substeps:
providing, on an outer surface of a soldering carrier, a bearing surface for attaching the cell, and enabling the bearing surface to be an outwardly protruding cambered surface;
attaching the cell to the bearing surface, and allowing a side surface of the cell to face outwards to be an outer side surface of the cell, wherein the strip-shaped conductive connection member is to be soldered on the side surface;
tightening and attaching the strip-shaped conductive connection member to the outer side surface of the cell; and
heating the strip-shaped conductive connection member, such that the strip-shaped conductive connection member is soldered on the cell.

2. The solar cell soldering method according to claim 1, **characterized in that** the outer side surface of the cell is provided with a plurality of grid lines parallel to each other;
when the cell is attached to the bearing surface, an extension direction of the plurality of grid lines on the outer side surface of the cell is allowed to be perpendicular to an axis of the bearing surface; and
when the strip-shaped conductive connection member is tightened and attached to the outer side surface of the cell, the strip-shaped conductive connection member is correspondingly attached to the plurality of grid lines on the outer side surface of the cell.

3. The solar cell soldering method according to claim 1 or 2, **characterized in that** the strip-shaped conductive connection member is tightened and attached to the outer side surface of the cell by allowing the strip-shaped conductive connection member to span across the cell along a circumferential direction of the bearing surface and pulling sections of the strip-shaped conductive connection member respectively located outside two sides of the cell tight towards the soldering carrier.

4. The solar cell soldering method according to claim 1 or 2, **characterized in that** a rotating shaft is provided on the soldering carrier, and the outer surface of the soldering carrier comprises a side circumferential surface around the rotating shaft, and the bearing surface is located on the side circumferential surface of the soldering carrier, and the axis of the bearing surface is parallel to or collinear with an axis of the rotating shaft; and
the strip-shaped conductive connection member is tightened and attached to the outer side surface of the cell by winding the strip-shaped conductive connection member along a circumferential direction of the side circumferential surface of the soldering carrier and pulling the strip-shaped conductive connection member tight to the cell on the side circumferential surface of the soldering carrier.

5. The solar cell soldering method according to claim 4, **characterized in that** the axis of the rotating shaft is located on a centerline of the soldering carrier.

6. The solar cell soldering method according to claim 4, **characterized in that** when the strip-shaped conductive connection member is wound along the circumferential direction of the side circumferential surface of the soldering carrier and pulled tight to the cell on the side circumferential surface of the soldering carrier, the side circumferential surface of the soldering carrier is rotated around the axis of the rotating shaft.

7. The solar cell soldering method according to claim 4, **characterized in that** at least two bearing surfaces are provided on the side circumferential surface of the soldering carrier, and an axis of each of the at least two bearing surfaces is parallel to or collinear with the axis of the rotating shaft;
a cell is attached to each of the at least two bearing surfaces, and a side surface of the cell on which the strip-shaped conductive connection member is to be soldered is allowed to face outwards to be an outer side surface of the cell;
the strip-shaped conductive connection member is tightened and attached to the outer side surface of the cell by winding the strip-shaped conductive connection member along the circumferential direction of the side circumferential surface of the soldering carrier and pulling the strip-shaped conductive connection member tight to the cell on the side circumferential surface of the soldering carrier; and
the strip-shaped conductive connection member is heated, such that the strip-shaped conductive connection member is soldered on the cell.

8. The solar cell soldering method according to claim 7, **characterized in that** a plurality of bearing surfaces are provided on the side circumferential surface of the soldering carrier, and the plurality of bearing surfaces are sequentially disposed along the circumferential direction of the side circumferential surface of the soldering carrier.

9. The solar cell soldering method according to claim 8, **characterized in that** the plurality of bearing surfaces are uniformly distributed along the circumferential direction of the side circumferential surface of the soldering carrier.

10. The solar cell soldering method according to claim 7, **characterized in that** a plurality of rows of bearing surfaces are provided on the side circumferential surface of the soldering carrier, the plurality of rows of bearing surfaces are sequentially disposed along the circumferential direction of the side circumferential surface of the soldering carrier, bearing surfaces in an identical row of the plurality of rows of bearing surfaces are sequentially disposed along an axial direction of the rotating shaft, and an axis of each bearing surface of the plurality of rows of bearing surfaces is parallel to or collinear with the axis of the rotating shaft.

11. The solar cell soldering method according to claim 10, **characterized in that** the plurality of rows of bearing surfaces are uniformly distributed along the circumferential direction of the side circumferential surface of the soldering carrier.

12. The solar cell soldering method according to claim 11, **characterized in that** the plurality of rows of bearing surfaces are uniformly distributed on the side circumferential surface of the soldering carrier.

13. The solar cell soldering method according to claim 7, **characterized in that** the side circumferential surface of the soldering carrier is surrounded by the at least two bearing surfaces.

14. The solar cell soldering method according to claim 13, **characterized in that** the side circumferential surface of the soldering carrier is coaxial with the rotating shaft.

15. The solar cell soldering method according to claim 7, **characterized in that** the side circumferential surface of the soldering carrier is a circumferential surface coaxial with the rotating shaft.

16. The solar cell soldering method according to claim 4, **characterized in that** one strip-shaped conductive connection member is used, and the one strip-shaped conductive connection member is wound along the circumferential direction of the side circumferential surface of the soldering carrier and pulled tight to the cell on the side circumferential surface of the soldering carrier.

17. The solar cell soldering method according to claim 1, **characterized in that** the strip-shaped conductive connection member is a solder wire or a solder ribbon.

18. The solar cell soldering method according to claim 1, **characterized in that** the strip-shaped conductive connection member has a flat and straight bottom surface for soldering to the cell; and
when the strip-shaped conductive connection member is tightened and attached to the outer side surface of the cell, the flat and straight bottom surface of the strip-shaped conductive connection member is allowed to face the outer side surface of the cell.

19. The solar cell soldering method according to claim 1, **characterized in that** the strip-shaped conductive connection member is heated through direct heating, infrared heating, or hot air heating.

20. The solar cell soldering method according to claim 19, **characterized in that** the soldering carrier is provided with a heating function, and the cell on the bearing surface and the strip-shaped conductive connection member on the outer side surface of the cell are heated through the soldering carrier.

21. The solar cell soldering method according to claim 1, **characterized in that** the bearing surface is provided with a vacuum adsorption function, and a vacuum adsorption is performed on the cell when the cell is attached to the bearing surface.

22. The solar cell soldering method according to claim 1, **characterized in that** after the strip-shaped conductive connection member is soldered on the cell, the strip-shaped conductive connection member is cut off to leave a small section of the strip-shaped conductive connection member on the cell, and the small section of the strip-shaped conductive connection member is configured for a serial connection of the cell on which the small section of the strip-shaped conductive connection member is located, and then the cell is removed from the bearing surface of the soldering carrier.

23. The solar cell soldering method according to claim 22, **characterized in that** the step of soldering the strip-shaped conductive connection member to the surface of the cell is performed on a front surface and a back surface of the cell individually to solder strip-shaped conductive connection members to the front surface and the back surface of the cell, respectively.
